# EUROPÄISCHE PATENTSCHRIFT

(11) **EP 2 486 602 B1**
(45) Veröffentlichungstag und Bekanntmachung des Hinweises auf die Patenterteilung: **16.01.2013**
(21) Anmeldenummer: 09740289.5
(22) Anmeldetag: 08.10.2009
(51) Int. Cl.: H01L 31/18, B28D 5/00, B28D 5/02

(54) **Vorrichtung und Verfahren zum Entschichten von Solarmodulen**
Device and method for removing coatings from solar modules
Dispositif et procédé d'enlèvement de couche des modules solaires

(43) Veröffentlichungstag der Anmeldung: 15.08.2012
(73) Patentinhaber: Komax Holding AG, 6036 Dierikon (CH)
(72) Erfinder: SUTER, Pascal, CH-6331 Hünenberg (CH); HOFER, Adolf, CH-8426 Lufingen (CH)
(74) Vertreter: Blöchle, Hans
(86) Internationale Anmeldenummer: PCT/EP2009/063096
(87) Internationale Veröffentlichungsnummer: WO 2011/042057

(56) Entgegenhaltungen:
- EP-A1- 0 769 348
- WO-A1-2008/107087
- JP-A- 4 309 224
- JP-A- 6 015 634
- JP-A- 10 202 648
- JP-A- 2000 315 809

## Beschreibung

Die vorliegende Erfindung betrifft eine Vorrichtung und ein entsprechendes Verfahren mit dieser Vorrichtung zum sogenannten Entschichten bzw. Entfernen von Schichten im Randbereich von Solarmodulen bzw. von Dünnfilmsolarmodulen.

Solarmodule bzw. Dünnfilmsolarmodule benötigen eine elektrische Verbindung zu einem externen Stromkreis. Der auf der aktiven Fläche produzierte Strom wird typischerweise mittels langer Metallbändchen an dem positiven und an dem negativen Pol des Moduls gesammelt und aus dem Modul herausgeleitet. Die Verbindung zwischen den Kontaktflächen auf dem Modul und dem Metallbändchen muss über die Lebensdauer des Moduls einen niedrigen elektrischen Widerstand garantieren.

Die CIS- (Kupfer-Indium-Selen oder Kupfer-Indium-Diselenid oder Kupfer-Indium-Disulfid) bzw. die CIGS- (Kupfer-Indium-Gallium-Selen oder Kupfer-Indium-Gallium-Diselenid oder Kupfer-Indium-Gallium-Disulfid) Dünnfilmtechnologie ist bekannt für hohe erzielbare Wirkungsgrade. Bei dieser Technologie wird typischerweise auf ein Glassubstrat eine metallische Schicht aufgebracht, gefolgt von einer CI(G)S-Absorberschicht und der transparenten leitenden Schicht (TCO-Schicht, wobei TCO für Transparent Conductive Oxide steht). Diese TCO-Schicht und die Absorberschicht werden üblicherweise an den Plus- und Minuspolen wieder entfernt, damit die Metallisierung direkt und niedrigohmig kontaktiert werden kann.

Das Entfernen der TCO- und der Absorberschicht muss möglichst vollständig, jedoch ohne Verletzung der Metallisierungsschicht erfolgen. Die anschliessend gereinigte Fläche soll möglichst scharfkantig begrenzt sein, da sonst wertvolle aktive Fläche verlorengeht.

Nebst diesem Entfernen, das Kontaktentschichtung genannt wird, kann der Randbereich des Dünnfilmsolarmoduls von allen aufgebrachten Schichten befreit werden, um eine elektrische Isolation gegenüber der Umwelt bewerkstelligen zu können und um beispielsweise optimale Bedingungen für das Auftragen von Dichtungsmaterial zu schaffen. Diese Randentschichtung ist weniger anspruchsvoll und kann durch Schleifen erreicht werden, kann aber im Prinzip auch mit denselben Verfahren durchgeführt werden, die auch für die Kontaktentschichtung Verwendung finden.

Für das Kontaktentschichten bzw. für das Randentschichten haben sich folgende Verfahren gemäss Stand der Technik etabliert:
a) Die zu entfernenden Schichten werden mit einem scharfkantigen Glas- oder Metallwerkzeug weggeschabt. Dieses Verfahren kommt vorwiegend als manuelle bzw. eine im Labormassstab angewandte Reinigungsmethode in Betracht. Automatisierungsversuche sind aufwändig und ergeben eine relativ lange Bearbeitungszeit, weil das Erreichen der gewünschten End-Schabtiefe in mehrere Bearbeitungsprozesse zerlegt werden muss.
b) Beim Sandstrahlen werden die zu entfernenden Schichten mit einem Strahlgut beschossen und dadurch entfernt. Nachteilig ist bei diesem Verfahren jedoch, dass einerseits keine optimale Kantenschärfe erzielbar ist und andererseits besteht die Gefahr, dass die Metallisierung teilweise beschädigt wird. Des Weiteren ist die Entsorgung oder eine Wiederverwertung des gebrauchten Strahlguts kostenintensiv. Die Entsorgung ist unter Umständen als Sondermüll oder sogar als Giftmüll erforderlich, und eine Wiederverwertung des Strahlguts bedarf einer Separierung von den abgetragenen Substanzen.
c) Die internationale Veröffentlichungsschrift WO-A2-2008/120102 offenbart eine Ablation, d.h. ein Abtragen der zu entfernenden Schichten durch Aufheizung mittels eines Lasers. Dieses Verfahren ist jedoch sehr teuer.
d) Die internationale Veröffentlichungsschrift WO-A1-2008/107087 offenbart eine Vorrichtung zum Abbürsten der zu entfernenden Schichten, beispielsweise durch die Verwendung von Bürsten mit Borsten aus Stahl. Bei diesem Verfahren ist jedoch nachteilig, dass die Stahlborsten die Metallisierung beschädigen können, sofern die Stahlborsten härter als das Material sind, aus dem die Metallisierung besteht. Nachteilig ist auch, dass sich das abgetragene Material zwischen den Borsten festsetzen kann und auf der Metallisierung verschmiert wird. Weiterhin nachteilig ist, dass die Biegebeanspruchung der Borsten eine genaue Ausarbeitung einer Kante, aber auch ein genaues Erreichen der gewünschten Bearbeitungstiefe verhindert oder zumindest erschwert.

Die Aufgabe der vorliegenden Erfindung ist, eine Vorrichtung und ein entsprechendes Verfahren unter Anwendung dieser Vorrichtung zu stellen, mit denen eine hohe Genauigkeit erreicht werden kann, das Entschichten von Solarmodulen generell optimiert ist - indem beispielsweise im Speziellen wenig Werkzeugverschleiss auftritt, die Bearbeitungszeit verkürzt ist und somit die Kosten gesenkt sind.

Die Lösung der Aufgabe besteht in der Konzeption und Ausgestaltung einer Vorrichtung mit einem rotierbaren Schaber.

Ein erfindungsgemässer rotierbarer Schaber ist vorzugsweise zylinderförmig oder zylinderrohrförmig ausgestaltet und verfügt vorzugsweise über abgeflachte Zacken bzw. Zähne. Diese Zacken bzw. Zähne können beispielsweise einfach durch Aussparungen aus dem Körper des Zylinders oder Zylinderrohres gebildet sein.

Die Zacken bzw. Zähne sind an ihren Stirnseiten vorzugsweise abgeflacht, d.h., sie bilden eine Fläche, die senkrecht zu der Achse des rotierbaren Schabers steht. Diese abgeflachten Stirnseiten sind vorzugsweise als Schleifflächen ausgebildet, die einerseits - quasi in einem einzigen Arbeitsprozess - die durch die Zacken bzw. Zähne bearbeitete Materialoberfläche abschleifen, d.h., sie glätten bzw. Materialrückstände bis auf die Tiefe der Metallisierung entfernen, andererseits jedoch gleichzeitig zur Ausrichtung des rotierbaren Schabers auf der zu bearbeitenden Materialoberfläche dienen.

Letzteres Ausrichten des rotierbaren Schabers auf der zu bearbeitenden Materialoberfläche ist vorzugsweise realisiert, indem der rotierbare Schaber in einem Kugel- oder in einem Kreuzgelenk gelagert ist. Auf diese Weise ist erfindungsgemäss gewährleistet, dass sich der rotierbare Schaber einerseits einer nicht exakt planen, waagerechten Ausrichtung des Solarmoduls anpasst, sowie andererseits allfällige Materialunebenheiten oder sogar absichtlich ausgestaltete Wölbungen ausgleicht. Der rotierbare Schaber wird vorzugsweise mit hoher Rotations- und Vorschubgeschwindigkeit über die zu bearbeitenden Schichten bewegt. Das Verhältnis zwischen Drehzahl und Vorschubgeschwindigkeit bestimmt, wie oft ein Punkt auf den zu bearbeitenden Schichten von einer Schabkante bearbeitet wird.

Die drehmomentübertragende Verbindung zwischen der Antriebswelle und dem rotierbaren Schaber ist, wie erwähnt, vorzugsweise über ein Kugel- oder ein Kreuzgelenk realisiert. Im Falle eines Kugelgelenks ist vorzugsweise ein Verbindungsstift durch eine Aufnahme des rotierbaren Schabers und eine entsprechende Bohrung in der Antriebswelle eingesetzt. Die Aufnahme des rotierbaren Schabers weist vorzugsweise ein Langloch auf, sodass der Verbindungsstift mit Spiel gelagert ist und eine Schwenkbarkeit des rotierbaren Schabers resultiert, bei gleichzeitiger Gewährleistung der Übertragung des Drehmoments.

Eine optionale Ausgestaltungsvariante der drehmomentübertragenden Verbindung mittels eines Kugelgelenks sieht Schlitze in dem Kugelkopf vor, in die Mitnehmer an einer halbkugelförmigen Aufnahme des rotierbaren Schabers einsetzbar sind. Die halbkugelförmige Aufnahme des rotierbaren Schabers wird auf dem Kugelkopf vorzugsweise mit einer hohlen und kugelschnittförmigen Mutter gefasst, sodass einerseits eine geführte Übertragung des Anpressdruckes der Antriebswelle auf den rotierbaren Schaber, und andererseits eine auf dem Kugelkopf geführte Schwenkbarkeit des rotierbaren Schabers gewährleistet ist, die vorteilhafterweise in alle Richtungen möglich ist.

Grundsätzlich und alternativ ist auch eine schwenkbare Verbindung zwischen der Antriebswelle und dem rotierbaren Schaber möglich, die lediglich über Reibung funktioniert. Im Rahmen der Offenbarung der vorliegenden Anmeldung liegen jedoch auch starre, nicht schwenkbare Verbindungen zwischen der Antriebswelle und dem rotierbaren Schaber, die dann aber allerdings einer exakten Ausrichtung des Solarmoduls zu dem rotierbaren Schaber bedürfen.

Alternativ ist auch eine Ausgestaltungsvariante einer erfindungsgemässen Vorrichtung zum Entschichten von Solarmodulen realisierbar, bei der das Solarmodul, eingespannt auf einem bewegbaren Schlitten, an einem linear positionsfest, aber rotierbaren Schaber vorbeibewegt wird. Des Weiteren ist optional eine Vorrichtung zum Entschichten von Solarmodulen denkbar, bei der besagter Schlitten linear gegenläufig zu der linearen Bewegung des rotierbaren Schabers bewegbar ist, sodass sich besonders hohe Bearbeitungsgeschwindigkeiten und somit besonders kurze Bearbeitungsprozesse ergeben.

Die Zacken bzw. Zähne des rotierbaren Schabers sind vorzugsweise so angeordnet, dass sie sich durch die Bearbeitung selbst schärfen. Ein erfindungsgemässer rotierbarer Schaber weist vorzugsweise 6-12 Zacken bzw. Zähne auf, die einen Aussendurchmesser bilden, der der bearbeiteten Fläche entspricht. Die Seitenflächen der Zacken bzw. Zähne sind vorzugsweise radial ausgerichtet und bilden mit den Stirnflächen einen Winkel, der in einem Bereich von 50 bis 130 Grad liegt, vorzugsweise jedoch circa 90 Grad beträgt. Je kleiner dieser Winkel ist, desto aggressiver wird das Schabverhalten.

Die Seitenflächen der Zacken bzw. Zähne des rotierbaren Schabers können jedoch auch nichtradial ausgerichtet sein. Dieses kann je nach dem Spanverhalten des Materials der zu bearbeitenden Oberflächen von Vorteil für dessen Abtransport sein. Des Weiteren ist es möglich, eine Absaugvorrichtung extern am rotierbaren Schaber oder aber auch intern in der Drehachse integriert vorzusehen.

Der rotierbare Schaber wird vorzugsweise von einer Antriebswelle angetrieben und die das Drehmoment übertragende Verbindung ist vorzugsweise, wie schon erwähnt, ein Kugel- oder ein Kreuzgelenk. Die Antriebswelle drückt den rotierbaren Schaber vorzugsweise mit einer konstanten Anpresskraft auf die zu bearbeitenden Materialoberflächen. Diese konstante Anpresskraft kann beispielsweise durch Pneumatikzylinder erzeugt werden.

Eine weiterhin bevorzugte Ausgestaltungsvariante einer erfindungsgemässen Vorrichtung zum Entschichten von Solarmodulen sieht jedoch vor, dass die Pneumatikzylinder die Anpresskraft variieren können. Dadurch ist auf jeden Fall gewährleistet, dass wechselnder Gegendruck - beispielsweise hervorgerufen durch unterschiedliche Materialstärke oder durch unterschiedliche Materialbeschaffenheit der zu bearbeitenden Oberflächen - den rotierbaren Schaber nicht eine Bearbeitungsfläche mit unterschiedlicher Bearbeitungstiefe erzeugen lässt.

Eine bevorzugte Ausgestaltungsvariante eines erfindungsgemässen rotierbaren Schabers sieht vor, dass das Material, aus dem der rotierbare Schaber gefertigt ist, auf jeden Fall härter als das Material der zu bearbeitenden Schichten ist. Des Weiteren jedoch ist es bevorzugt, dass die Härte des Materials, aus dem der rotierbare Schaber hergestellt ist, unterhalb der Materialhärte der Metallisierung bleibt, sodass Beschädigungen der Letzteren möglichst vermieden werden. Als Material für den rotierbaren Schaber kommen erfindungsgemäss beispielsweise un- oder niedriglegierter Stahl, Kupfer, Kupferbronze, Messing, Kupfer-Wolfram-Legierungen und Titan in Betracht. Auch eine weichere Grundmatrix, gefüllt mit Partikeln aus den genannten Materialien, ist denkbar.

Bei geeigneter Materialwahl nutzt sich der rotierbare Schaber durch den Kontakt mit der härteren Metallisierung vorwiegend an den Schleifflächen ab. Dadurch werden die Schabkanten während dem Betrieb laufend selbsttätig geschärft. Die Schabgeometrie bleibt auch bei Abnutzung des rotierbaren Schabers erhalten.

Die Schleifflächen an den senkrecht zu der Achse des rotierenden Schabers stehenden Stirnseiten können separat durch das Auftragen eines entsprechenden Materials als Schleifflächen ausgebildet sein. Bevorzugt ist es jedoch, den gesamten rotierenden Schaber aus einem einzigen Material zu fertigen, wie es beispielsweise in Absatz [0020] angegeben wurde. Optional kann das Material, die Legierung oder die Grundmatrix als ein Trägermaterial ausgestaltet sein, dem schleifende Partikel beigemengt sind.

Bei einer bevorzugten Ausgestaltungsvariante einer erfindungsgemässen Vorrichtung zum Entschichten von Solarmodulen ist es vorgesehen, dass der rotierbare Schaber sowohl linksdrehend, als auch rechtsdrehend betreibbar ist. Dieses kann einerseits Vorteile bei der Bearbeitung ergeben, garantiert andererseits jedoch eine Symmetrie bei der Abnutzung und auch bei der Selbstschärfung.

Wie schon erwähnt, ist ein möglicher Parameter zur Steuerung bzw. zur Kontrolle des Bearbeitungsprozesses mit einer erfindungsgemässen Vorrichtung zum Entschichten von Solarmodulen der Anpressdruck des rotierbaren Schabers. Weitere Parameter sind die Drehzahl des rotierbaren Schabers oder die Drehzahl der Antriebswelle, das Drehmoment des Antriebs oder die Vorschubgeschwindigkeit. Es ist bevorzugt, diese Parameter vorzugsweise rechnerunterstützt zu erfassen und beispielsweise über einen Drehmomentbegrenzer ein unerwünschtes Schaben der Metallisierung zusätzlich auszuschliessen.

Eine weitere erfindungsgemässe Massnahme zur Vermeidung der Beschädigung der Metallisierung ist, die Metallisierung bei der Bearbeitung unter Spannung zu setzen. Wenn der rotierbare Schaber mit der Metallisierung elektrischen Kontakt bekommt, ist dieses ein Stromimpuls, der als Signal verwertbar ist - beispielsweise für einen Stopp, eine Meldung oder für eine automatische Minderung des Anpressdruckes in dem Pneumatikzylinder oder den Pneumatikzylindern, der oder die den rotierbaren Schaber auf die zu bearbeitenden Oberflächen andrückt oder andrücken. Denkbar sind auch einer oder mehrere Kontaktfinger, die dem rotierbaren Schaber nachlaufen und bei blanker, Kontakt gebender Metallisierung einen Stromimpuls für die Erzeugung eines oben erwähnten Signals weiterleiten.

Optional können die Schabflächen des rotierbaren Schabers mit Wendeschneidplatten ausgestattet sein, d.h. Schneidstoffträgern mit mehreren Schneidkanten, die in einer hierfür vorgesehenen Haltevorrichtung einschraubbar oder einklemmbar sind und nach Abnutzung einer Schneidkante aus der Haltevorrichtung gelöst, gewendet und erneut eingeschraubt oder eingeklemmt werden.

Eine erfindungsgemässe Vorrichtung zum Entschichten von Solarmodulen bzw. ein Verfahren mit einer entsprechenden Vorrichtung bringt folgende Vorteile:
- Die Vorrichtung ist relativ kompakt und kostengünstig.
- Der rotierbare Schaber ist selbstschärfend ausgestaltet und garantiert somit lange Werkzeug-Standzeiten.
- Der Bearbeitungsprozess ergibt eine hohe Kantengenauigkeit zwischen dem bearbeiteten und dem nicht bearbeiteten Bereich.
- Der Bearbeitungsprozess ist schonend und vermeidet eine Beschädigung der Metallisierung weitestgehend.
- Die Vorrichtung gleicht Unebenheiten oder unterschiedliche Materialstärken aus.
- Die Vorrichtung bietet eine Inline-Prozesskontrolle, vorzugsweise rechnerunterstützt.

Weitere oder vorteilhafte Ausgestaltungen einer erfindungsgemässen Vorrichtung bilden die Gegenstände der abhängigen Ansprüche.

Anhand von Figuren wird die Erfindung symbolisch und beispielhaft näher erläutert. Die Figuren werden zusammenhängend und übergreifend beschrieben. Sie stellen schematische und beispielhafte Darstellungen dar und sind nicht massstabagetreu, auch in der Relation der einzelnen Bestandteile zueinander nicht. Gleiche Bezugszeichen bedeuten gleiche Bauteile, Bezugszeichen mit unterschiedlichen Indices geben funktionsgleiche oder ähnliche Bauteile an.

Es zeigen dabei
Fig. 1 eine schematische Darstellung eines Dünnfilmsolarmoduls;
Fig. 2 eine schematische Detaildarstellung eines erfindungsgemässen rotierbaren Schabers;
Fig. 3 eine weitere schematische Detaildarstellung des erfindungsgemässen rotierbaren Schabers aus der Fig. 2;
Fig. 4 eine weitere schematische Detaildarstellung des erfindungsgemässen rotierbaren Schabers aus der Fig. 2 bzw. aus der Fig. 3;
Fig. 5 eine schematische Detaildarstellung des erfindungsgemässen rotierbaren Schabers aus den vorhergehenden Figuren und eines erfindungsgemässen Wellenantriebs;
Fig. 6 eine schematische Detaildarstellung einer alternativen Ausgestaltungsvariante eines erfindungsgemässen Wellenantriebs und
Fig. 7 eine schematische und perspektivische Detaildarstellung einer erfindungsgemässen Entschichtungs-Vorrichtung.

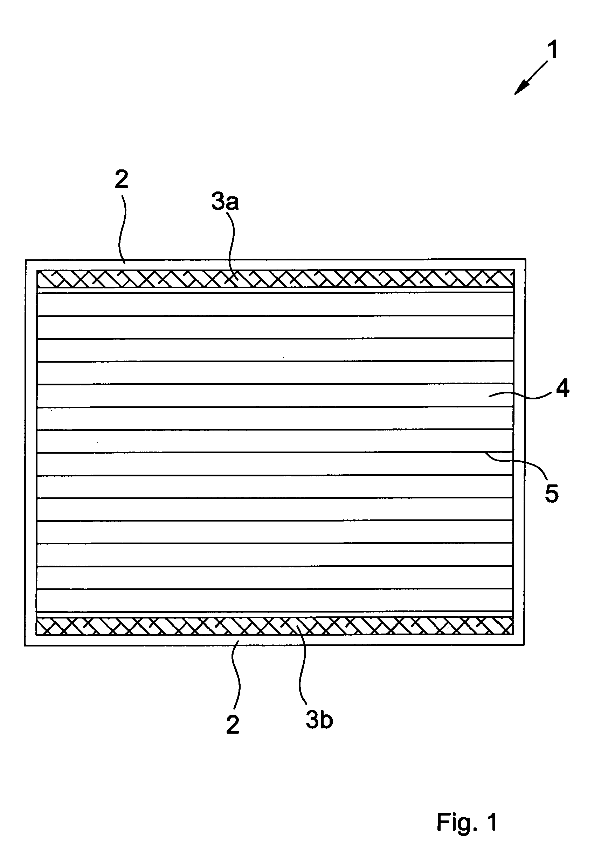

Die Fig. 1 zeigt eine schematische Darstellung eines Dünnfilmsolarmoduls 1 oder auch generell eines Solarmoduls 1, das im fertig bearbeiteten Zustand eine randentschichtete Zone 2; zwei kontaktentschichtete Zonen 3a und 3b; einzelne, aneinandergereihte Solarzellen, von denen nur eine beispielhaft als Solarzelle 4 bezeichnet ist; sowie die einzelnen Solarzellen begrenzende Laserscribes aufweist, von denen auch lediglich exemplarisch nur ein Laserscribe 5 bezeichnet ist. Laserscribes sind bei Solarzellen üblicherweise angewandte Abtrennungen, die durch Lasergravur, -ätzung oder -markierung erzeugt werden. Sie begrenzen die einzelnen Solarzellen und dienen der internen Serienschaltung der einzelnen Solarzellen.

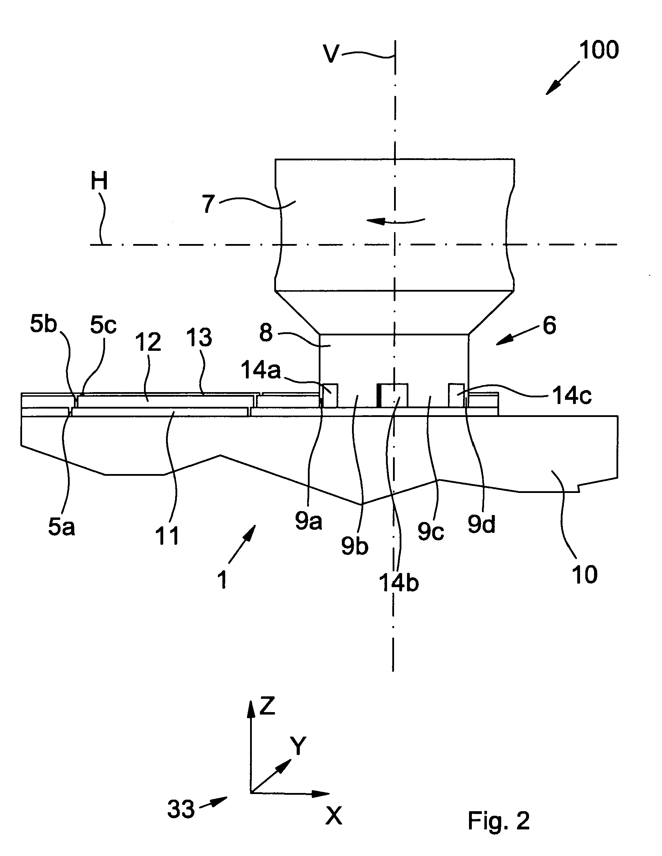

Die Fig. 2 zeigt eine schematische Darstellung eines erfindungsgemässen rotierbaren Schabers 6, wie er in einer lediglich nur angedeuteten erfindungsgemässen Entschichtungs-Vorrichtung 100 zum Entschichten von Solarmodulen 1 zur Anwendung gelangt. Das Solarmodul 1 besteht grundsätzlich aus einer Trägerplatte 10, die meistens aus Glas oder einem Glassubstrat ist, einer auf dieser Trägerplatte 10 aufgebrachten Metallisierung 11, einer wiederum auf dieser Metallisierung 11 aufgebrachten Absorberschicht 12 und einer obersten TCO-Schicht 13. Die Metallisierung 11, die Absorberschicht 12 und die TCO-Schicht 13 sind durch Laserscribes 5a-5c durchsetzt.

Der rotierbare Schaber 6 weist eine Aufnahme 7 und einen Schabkopf 8 auf, in dem durch Aussparungen 14a-14c aus dem vorzugsweise hohlen Schabkopf 8 Zacken bzw. Zähne 9a-9d gebildet sind. Der rotierbare Schaber 6 wird dem Pfeil entsprechend um eine Achse rotiert, die annähernd einer Vertikalen V entspricht und gleichzeitig linear senkrecht in die Zeichnungsebene hinein entlang einer Achse Y eines Koordinatensystems 33 bewegt, sodass die Absorberschicht 12 und die TCO-Schicht 13 über die Breite des Aussendurchmessers des Schabkopfes 8 weggeschabt werden. Das Koordinatensystem 33 ist in der Relation zu der zweidimensionalen Darstellung der erfindungsgemässen Entschichtungs-Vorrichtung 100 bzw. des erfindungsgemässen rotierbaren Schabers 6 insofern nur als symbolisch zu verstehen, als dass eine Achse X des Koordinatensystems 33 annähernd einer Horizontalen H entspricht, eine Achse Z des Koordinatensystems 33 annähernd der Vertikalen V und die Achse Y des Koordinatensystems 33 nicht diagonal zur Seite ausgerichtet ist, sondern senkrecht in die Zeichnungsebene hinein, bzw. sowohl zu der Vertikalen V, als auch gleichzeitig zu der Horizontalen H senkrecht.

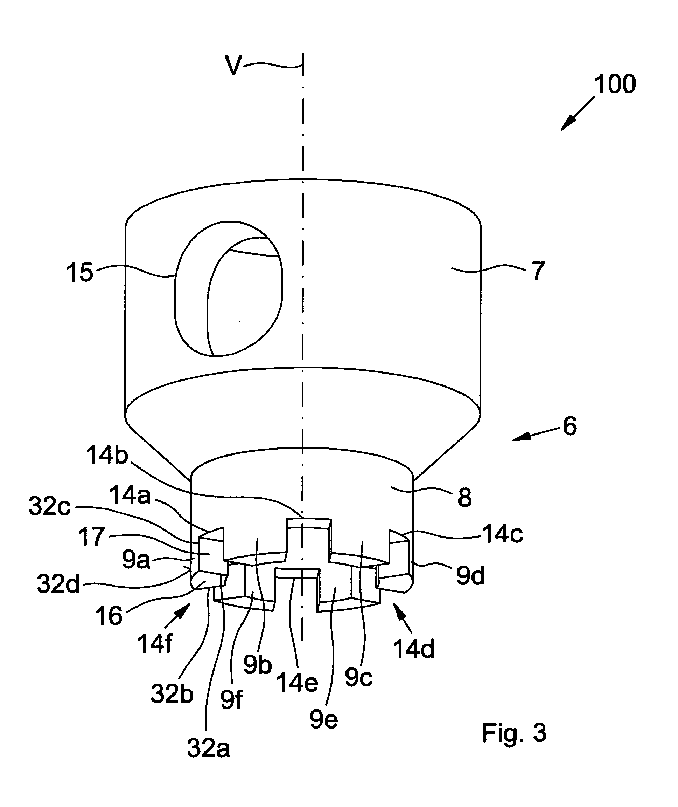

In der Fig. 3 ist der rotierbare Schaber 6 aus der Fig. 2 detaillierter und perspektivisch dargestellt, sodass jetzt sechs Zacken bzw. Zähne 9a-9f ersichtlich sind, die durch Aussparungen 14a-14f gebildet sind. Der Einfachheit halber ist beispielhaft nur an dem Zacken bzw. Zahn 9a dargestellt, dass jeder der Zacken bzw. Zähne 9a-9f eine Stirnfläche 16 und eine Seitenfläche 17 ausbildet. Der Zacken bzw. Zahn 9a weist somit vier Schabkanten 32a-32d auf, eine Schabkante 32a zwischen der Stirnfläche 16 und der Seitenfläche 17, eine weitere Schabkante 32b zwischen der Stirnfläche 16 und einer rückwärtigen, nicht näher bezeichneten, aber der Seitenfläche 17 identischen und gegenüberliegenden Seitenfläche, und zwei Schabkanten 32c und 32d, gebildet von den Seitenflächen und dem Aussendurchmesser des Schabkopfes 8. Die Stirnfläche 16 ist vorzugsweise als Schleiffläche ausgestaltet. Die dargestellte Anordnung von Zacken bzw. Zähnen 9a-9f ist selbstschärfend und bearbeitet das Solarmodul sowohl bei links-, als auch bei rechtsdrehendem rotierbarem Schaber.

Die Aufnahme 7 weist vorzugsweise ein Langloch 15 auf, für einen Verbindungsstift, der im Folgenden noch gezeigt werden wird.

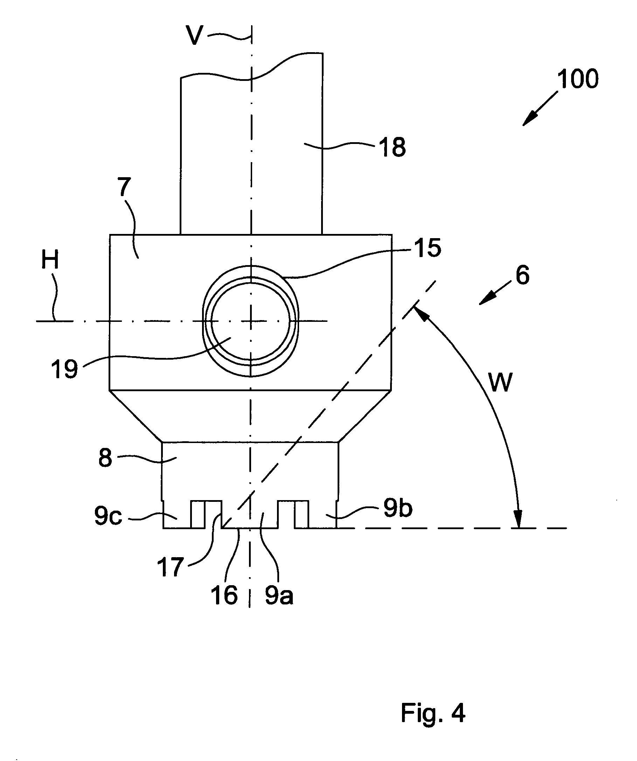

Die Fig. 4 zeigt erneut den erfindungsgemässen rotierbaren Schaber 6 aus den bisherigen Figuren 2 und 3, nun jedoch mit einer Antriebswelle 18 mittels eines Verbindungsstifts 19 verbunden, indem der Verbindungsstift 19 in einer Bohrung 31 in der Antriebswelle 18 angeordnet ist. Dadurch wiederum, dass der Verbindungsstift 19 mit Spiel gleichzeitig in das Langloch 15 eingesetzt ist, sind zwei Schwenkbarkeiten des rotierbaren Schabers 6 auf der Antriebswelle 18 möglich. Die eine Schwenkbarkeit dreht um eine annähernd senkrecht aus der Zeichnungsebene herausragende Achse, bzw. einer zu der Vertikalen V annähernd senkrecht stehenden Achse, und die zweite Schwenkbarkeit dreht um die Horizontale H, innerhalb des Spielraumes, den das Langloch 15 in der Vertikalen V freigibt.

Zur Sicherung des Verbindungsstiftes 19 kann er in Presssitz in die Bohrung 31 eingesetzt sein, es ist jedoch auch eine Ausgestaltungsvariante eines Verbindungsstiftes möglich, die an einem Ende einen Kragen und am anderen Ende eine Bohrung für einen Splint aufweist.

Des Weiteren deutet die Fig. 4 an, dass zwischen der Stirnfläche 16 und der Seitenfläche 17 des Zackens bzw. Zahns 9a auch ein Winkel W gebildet sein kann, der spitz, rechtwinklig oder auch stumpf ist und somit unterschiedliche Schabgeometrien bei unterschiedlichen rotierbaren Schabern 6 Verwendung finden können. Der Winkel W kann in einem Bereich von 50-130 Grad liegen, beträgt jedoch vorzugsweise etwa 90 Grad. Je spitzer der Winkel W ist, desto aggressiver lässt er das Schabverhalten des rotierbaren Schabers 6 werden.

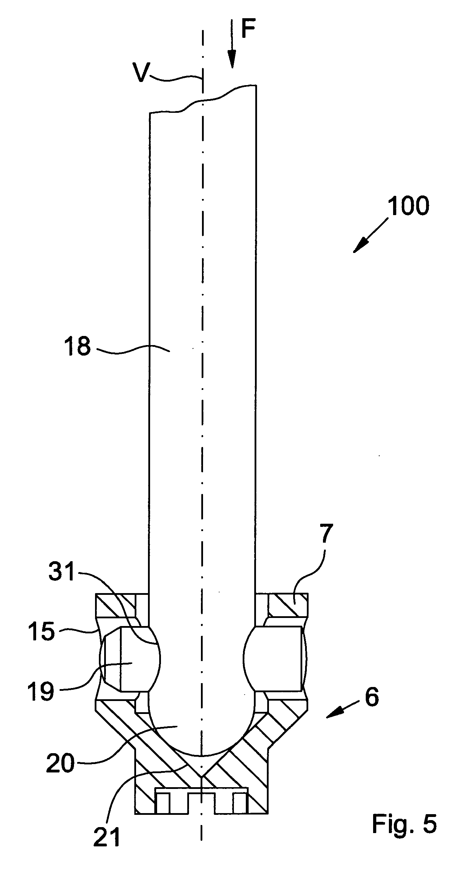

Die Fig. 5 zeigt die schwenkbare Verbindung aus der Fig. 4 zwischen dem rotierbaren Schaber 6 und der Antriebswelle 18 in einer partiellen Schnittdarstellung, sodass der Einsatz des Verbindungsstiftes 19 in dem Langloch 15 dergestalt ersichtlich ist, dass eine Schwenkbarkeit des rotierbaren Schabers 6 um eine aus der Zeichnungsebene herausragende Achse - entsprechend der Koordinatenachse Y - bzw. um eine zu der Vertikalen V und gleichzeitig zu der Koordinatenachse Z senkrecht stehenden Achse möglich ist.

Eine Anpresskraft F, die entlang der Vertikalen V wirkt, wird über einen Kugelkopf 20 der Antriebswelle 18 auf eine Pfanne bzw. Vertiefung 21 des rotierbaren Schabers 6 übertragen.

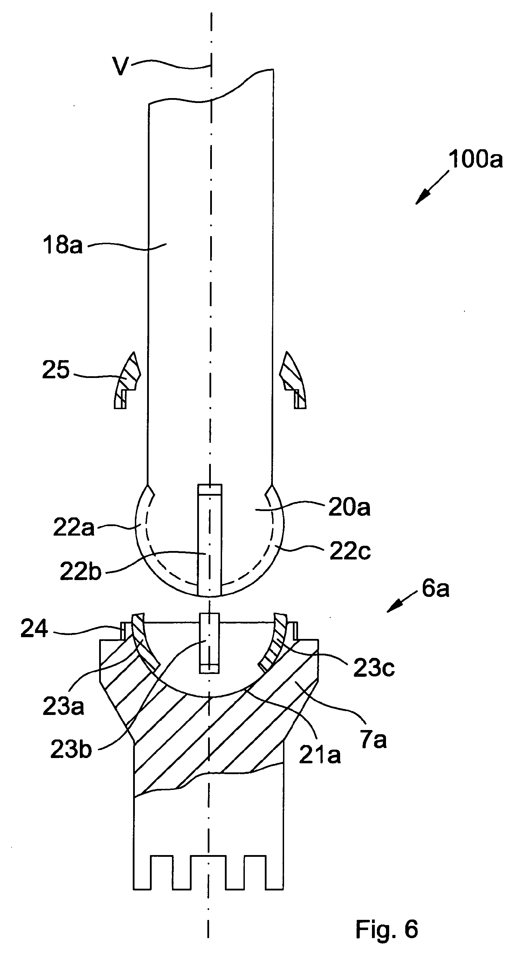

Die Fig. 6 zeigt eine weiterhin erfindungsgemässe Ausgestaltungsvariante einer schwenkbaren Verbindung zwischen einem rotierbaren Schaber 6a und einer Antriebswelle 18a. Diese optionale Verbindungsart ergibt somit eine weiterhin erfindungsgemässe Ausgestaltungsvariante einer Vorrichtung 100a zum Entschichten von Solarmodulen. Die Antriebswelle 18a weist einen Kugelkopf 20a auf, in den vorzugsweise vier oder auch mehr Schlitze eingearbeitet sind, von denen in dieser Ansicht Schlitze 22a-22c sichtbar sind. In diese Schlitze 22a-22c sind Mitnehmer 23a-23c einsetzbar, die in einer halbkugelförmigen Vertiefung 21a spiegelbildlich zu den Schlitzen 22a-22c angeordnet sind.

Die Mitnehmer 23a-23c sind in Draufsicht rechteckig dargestellt, siehe insbesondere den Mitnehmer 23b. Somit ergibt sich eine Schwenkbarkeit des rotierbaren Schabers 6a in dem Masse, wie lang und wie breit die rechteckige Form der Mitnehmer 23a-23c ist, bzw. mit wie viel Spiel die Mitnehmer 23a-23c in den Schlitzen 22a-22c sitzen. Auf diese Weise ist eine absichtlich begrenzbare Schwenkbarkeit des rotierbaren Schabers 6a realisierbar. Falls dieses nicht erwünscht ist, kann eine freie Schwenkbarkeit des rotierbaren Schabers 6a durch runde Mitnehmer 23a-23c oder auch durch halbkugelförmige Mitnehmer 23a-23c erreicht werden, wobei die Letzteren dann auch vorzugsweise in entsprechenden halbkugelförmigen Schlitzen 22a-22c sitzen.

Eine Aufnahme 7a des rotierbaren Schabers 6a weist des Weiteren ein Gewinde 24 auf, an dem eine hohle und kugelschnittförmige Mutter 25 aufschraubbar ist. Der Vorteil einer wie hier dargestellten Verbindung zwischen der Antriebswelle 18a und dem rotierbaren Schaber 6a ist eine in jede Richtung freie, aber gleichzeitig geführte Schwenkbarkeit des rotierbaren Schabers 6a, bei gleichzeitiger sicherer Übertragung des Drehmoments der Antriebswelle 18a.

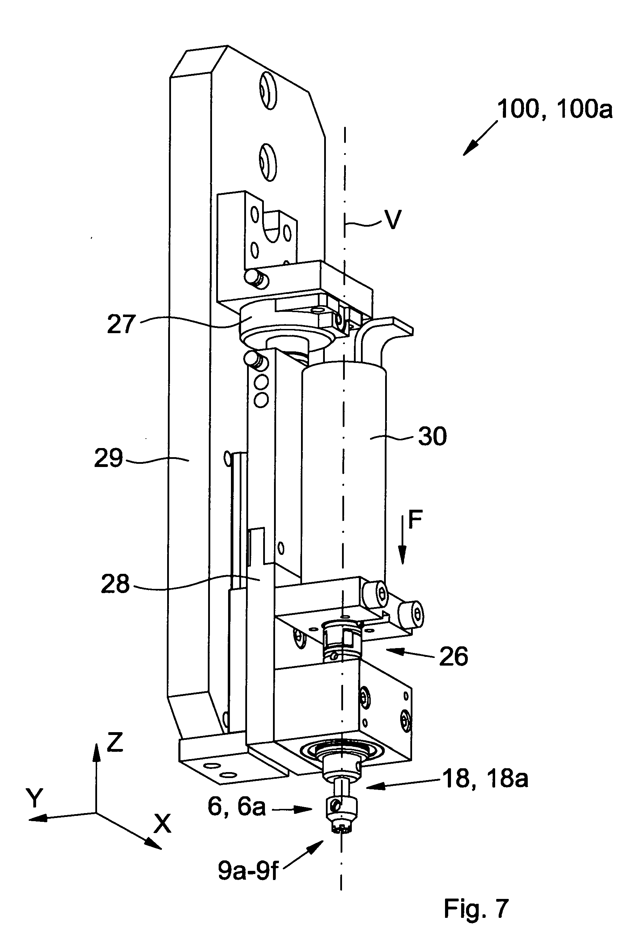

In der Fig. 7 ist die erfindungsgemässe Entschichtungs-Vorrichtung 100 bzw. 100a dargestellt, je nachdem, ob die schwenkbare Verbindung zwischen der Antriebswelle 18 bzw. 18a mit dem rotierbaren Schaber 6 bzw. 6a nach den Figuren 4 und 5 oder nach der Fig. 6 realisiert ist. Die Antriebswelle 18 bzw. 18a ist mittels einer Kupplung 26 mit einem Antrieb 30 verbunden und gleichzeitig von einem Zylinder 27 entlang der Vertikalen V bzw. der Koordinatenachse Z mit einer Anpresskraft F beaufschlagt. Die Vorrichtung 100 bzw. 100a weist des Weiteren vorzugsweise einen Vertikalschlitten 28 und einen Horizontalschlitten 29 auf, der vorzugsweise an einem X-Z-System zum Anheben und Absenken der gesamten Vorrichtung 100 bzw. 100a befestigt ist. Wie schon erwähnt, ist es jedoch auch möglich, optional oder zusätzlich einen nicht näher dargestellten Schlitten zur Aufnahme des Solarmoduls geführt beweglich an der Vorrichtung 100 bzw. 100a vorbeizuführen.

Eine bevorzugte Bearbeitungsabfolge mit einer erfindungsgemässen Vorrichtung 100 bzw. 100a zum Entschichten von Solarmodulen 1 umfasst folgende Schritte:
a) Fixieren des Solarmoduls 1 in einer Befestigung in Bezug zu der Vorrichtung 100 bzw. 100a;
b) Versetzen des rotierbaren Schabers 6 bzw. 6a in Rotation - vorzugsweise links- oder rechtsdrehend wählbar - um eine Achse, die der Vertikalen V bzw. der Koordinatenachse Z annähernd entspricht;
c) Absenken des rotierbaren Schabers 6 bzw. 6a auf die Oberfläche der obersten TCO-Schicht 13 des Solarmoduls 1, sodass die Stirnflächen 16 die Oberfläche der obersten TCO-Schicht 13 berühren und sich somit der rotierbare Schaber 6 bzw. 6a nach dieser Oberfläche ausrichtet;
d) Beaufschlagen des rotierbaren Schabers 6 bzw. 6a mit der Anpresskraft F in annähernder Richtung der Vertikalen V bzw. der senkrechten Koordinatenachse Z;
e) Verschieben des rotierbaren Schabers 6 bzw. 6a in annähernder Richtung mindestens einer waagerechten Koordinatenachse X mittels Verschiebens des Horizontalschlittens 29 oder/und mittels Verschiebens der in Schritt a) erwähnten Befestigung, die das Solarmodul 1 in Bezug zu der Entschichtungs-Vorrichtung 100 bzw. 100a fixiert.

### Bezugszeichenliste

- 1 -: Dünnfilmsolarmodul, Solarmodul
- 2 -: randentschichtete Zone
- 3a, 3b -: kontaktentschichtete Zone
- 4 -: Zelle
- 5, 5a-5c -: Laserscribe
- 6, 6a -: rotierbarer Schaber
- 7, 7a -: Aufnahme
- 8 -: Schabkopf
- 9a-9f -: Zacken, Zahn
- 10 -: Trägerplatte
- 11 -: Metallisierung
- 12 -: Absorberschicht
- 13 -: TCO-Schicht
- 14a-14c -: Aussparung
- 15 -: Langloch
- 16 -: Stirnfläche
- 17 -: Seitenfläche
- 18, 18a -: Antriebswelle
- 19 -: Verbindungsstift
- 20, 20a -: Kugelkopf
- 21, 21a -: Pfanne, Vertiefung
- 22a-22c -: Schlitz
- 23a-23c -: Mitnehmer
- 24 -: Gewinde
- 25 -: Mutter
- 26 -: Kupplung
- 27 -: Zylinder
- 28 -: Vertikalschlitten
- 29 -: Horizontalschlitten
- 30 -: Antrieb
- 31 -: Bohrung
- 32a-32d -: Schabkante
- 33 -: Koordinatensystem
- 100, 100a -: Entschichtungs-Vorrichtung
- F -: Anpresskraft
- H -: Horizontale
- V -: Vertikale
- W -: Winkel zwischen 16 und 17
- X, Y, Z -: Koordinatenachse

## Patentansprüche

1. Vorrichtung (100, 100a) zum Entschichten eines Solarmoduls (1), mit einem rotierbaren Schaber (6, 6a), der mit einer Antriebswelle (18, 18a) verbindbar ist und mittels dieser Antriebswelle (18, 18a) antreibbar und mit einer Anpresskraft (F) auf die Oberfläche des Solarmoduls (1) anpressbar ist, **dadurch gekennzeichnet, dass** der rotierbare Schaber (6, 6a) Zacken bzw. Zähne (9a-9f) mit Seitenflächen (17) und Stirnflächen (16) aufweist und wobei die Stirnflächen (16) der Zacken bzw. Zähne (9a-9f) als Schleifflächen ausgebildet sind.

2. Vorrichtung (100, 100a) nach Anspruch 1, **dadurch gekennzeichnet, dass** die Verbindung zwischen dem rotierbaren Schaber (6, 6a) und der Antriebswelle (18, 18a) mittels eines Kugel- oder eines Kreuzgelenks schwenkbar ist, so dass sich der rotierbare Schaber (6, 6a) durch die Stirnflächen (16) auf der Oberfläche des Solarmoduls (1) ausrichten kann.

3. Vorrichtung (100, 100a) nach Anspruch 2, **dadurch gekennzeichnet, dass** die schwenkbare Verbindung zwischen dem rotierbaren Schaber (6) und der Antriebswelle (18) einen Verbindungsstift (19) aufweist, der in einem Langloch (15) einsetzbar ist.

4. Vorrichtung (100, 100a) nach Anspruch 2, **Dadurch gekennzeichnet, dass** die schwenkbare Verbindung zwischen dem rotierbaren Schaber (6a) und der Antriebswelle (18a) einen Kugelkopf (20a) mit Schlitzen (22a-22c) aufweist, in die Mitnehmer (23a-23c) einer Aufnahme (7a) des rotierbaren Schabers (6a) einsetzbar sind.

5. Vorrichtung (100, 100a) nach einem der vorhergehenden Ansprüche, **dadurch gekennzeichnet, dass** das Solarmodul (1) an einem Schlitten befestigbar ist, welcher Schlitten an der Vorrichtung (100, 100a) vorbei geführt bewegbar ist.

6. Vorrichtung (100, 100a) nach einem der vorhergehenden Ansprüche, **dadurch gekennzeichnet, dass** die Stirnflächen (16) mit den Seitenflächen (17) einen Winkel (W) bilden, der in einem Bereich von 50 bis 130 Grad liegt, vorzugsweise jedoch 90 Grad beträgt.

7. Vorrichtung (100, 100a) nach einem der vorhergehenden Ansprüche, **dadurch gekennzeichnet, dass** die Anpresskraft (F) durch Pneumatikzylinder (27) erzeugbar und variabel ist.

8. Vorrichtung (100, 100a) nach einem der vorhergehenden Ansprüche, **dadurch gekennzeichnet, dass** das Material des rotierbaren Schabers härter (6, 6a) als die Materialien einer Absorberschicht (12) und einer TCO-Schicht (13) des Solarmoduls (1) ist und gleichzeitig weicher als das Material einer Metallisierung (11) des Solarmoduls (1).

9. Vorrichtung (100, 100a) nach einem der vorhergehenden Ansprüche, **dadurch gekennzeichnet, dass** der rotierbare Schaber (6, 6a) sowohl links-, als auch rechtsdrehend antreibbar ist.

10. Vorrichtung (100, 100a) nach einem der vorhergehenden Ansprüche, **dadurch gekennzeichnet, dass** das Drehmoment der Antriebswelle (18, 18a) durch einen Drehmomentbegrenzer begrenzbar ist.

11. Vorrichtung (100, 100a) nach einem der vorhergehenden Ansprüche, **dadurch gekennzeichnet, dass** die Metallisierung (11) des Solarmoduls (1) unter Spannung gestellt werden kann, und dass bei Kontakt mit der Vorrichtung (100, 100a) ein Signal zur Reduktion der Anpresskraft (F) ausgebbar ist.

12. Vorrichtung (100, 100a) nach einem der vorhergehenden Ansprüche, **dadurch gekennzeichnet, dass** an den Seitenflächen (17) der Zacken bzw. Zähne (9a-9f) Wendeschneidplatten anordenbar sind.

13. Verfahren zum Entschichten eines Solarmoduls (1), mit einer Vorrichtung (100, 100a) nach einem der vorhergehenden Ansprüche, mit folgenden Schritten:
a) Fixieren des Solarmoduls (1) in einer Befestigung in Bezug zu der Vorrichtung (100, 100a);
b) Rotieren eines Schabers (6, 6a) mit Zacken bzw. Zähnen (9a-9f) mit Seitenflächen (17) und Stirnflächen (16) mittels einer Antriebswelle (18, 18a) um eine vertikale (V) bzw. um eine senkrechte Koordinatenachse (Z);
c) Absenken des rotierbaren Schabers (6, 6a) auf die Oberfläche einer obersten TCO-Schicht (13) des Solarmoduls (1), sodass die Stirnflächen (16) die Oberfläche der obersten TCO-Schicht (13) berühren;
d) Beaufschlagen des rotierbaren Schabers (6, 6a) mit einer Anpresskraft (F) in Richtung der Vertikalen (V) bzw. der senkrechten Koordinatenachse (Z);
e) Verschieben des rotierbaren Schabers (6, 6a) in Richtung mindestens einer waagerechten Koordinatenachse (X) mittels Verschiebens eines Horizontalschlittens (29) oder/und mittels Verschiebens der Befestigung aus Schritt a).

## Claims

1. Device (100, 100a) for removing coatings from a solar module (1), with a rotatable scraper (6, 6a) which can be connected to a drive shaft (18, 18a) and can be driven by means of this drive shaft (18, 18a) and which can be pressed with a pressure force (F) onto the surface of the solar module (1), **characterized in that** the rotatable scraper (6, 6a) has serrations or teeth (9a-9f) with side faces (17) and with end faces (16), and the end faces (16) of the serrations or teeth (9a-9f) being designed as grinding surfaces.

2. Device (100, 100a) according to Claim 1, **characterized in that** the connection between the rotatable scraper (6, 6a) and the drive shaft (18, 18a) is pivotable by means of a ball joint or a universal joint, so that the rotatable scraper (6, 6a) can be oriented by means of the end faces (16) on the surface of the solar module (1).

3. Device (100, 100a) according to Claim 2, **characterized in that** the pivotable connection between the rotatable scraper (6) and the drive shaft (18) has a connecting pin (19) which can be inserted into a long hole (15).

4. Device (100, 100a) according to Claim 2, **characterized in that** the pivotable connection between the rotatable scraper (6a) and the drive shaft (18a) has a ball head (20a) with slots (22a-22c), into which dogs (23a-23c) of a receptacle (7a) of the rotatable scraper (6a) can be inserted.

5. Device (100, 100a) according to one of the preceding claims, **characterized in that** the solar module (1) can be fastened to a carriage which can be moved past the device (100, 100a) in a guided manner.

6. Device (100, 100a) according to one of the preceding claims, **characterized in that** the end faces (16) form with the side faces (17) an angle (W) which lies in a range of 50 to 130 degrees, but preferably amounts to 90 degrees.

7. Device (100, 100a) according to one of the preceding claims, **characterized in that** the pressure force (F) can be generated by pneumatic cylinders (27) and is variable.

8. Device (100, 100a) according to one of the preceding claims, **characterized in that** the material of the rotatable scraper (6, 6a) is harder than the materials of an absorber layer (12) and of a TCO layer (13) of the solar module (1) and at the same time is softer than the material of metallization (11) of the solar module (1).

9. Device (100, 100a) according to one of the preceding claims, **characterized in that** the rotatable scraper (6, 6a) can be driven both in left-hand and in right-hand rotation.

10. Device (100, 100a) according to one of the preceding claims, **characterized in that** the torque of the drive shaft (18, 18a) can be limited by a torque limiter.

11. Device (100, 100a) according to one of the preceding claims, **characterized in that** the metallization (11) of the solar module (1) can be set under tension, and **in that**, upon contact with the device (100, 100a), a signal for reducing the pressure force (F) can be output.

12. Device (100, 100a) according to one of the preceding claims, **characterized in that** indexable cutting inserts can be arranged on the side faces (17) of the serrations or teeth (9a-9f).

13. Method for removing coatings from a solar module (1), with a device (100, 100a) according to one of the preceding claims, comprising the following steps:
a) Fixing the solar module (1) in a fastening with respect to the device (100, 100a);
b) Rotating a scraper (6, 6a) with serrations or teeth (9a-9f) having side faces (17) and end faces (16) by means of a drive shaft (18, 18a) about a vertical (V) or about a perpendicular co-ordinate axis (Z);
c) Lowering of the rotatable scraper (6, 6a) onto the surface of an uppermost TCO layer (13) of the solar module (1), so that the end faces (16) touch the surface of the uppermost TCO layer (13);
d) Loading the rotatable scraper (6, 6a) with a pressure force (F) in the direction of the vertical (V) or of the perpendicular co-ordinate axis (Z);
e) Displacing the rotatable scraper (6, 6a) in the direction of at least one horizontal co-ordinate axis (X) by means of the displacement of a horizontal carriage (29) and/or by means of the displacement of the fastening from step a).

## Revendications

1. Dispositif (100, 100a) destiné à enlever des couches d'un module solaire (1), comprenant un racloir rotatif (6, 6a) pouvant être relié à un arbre d'entraînement (18, 18a), pouvant être entraîné au moyen dudit arbre d'entraînement (18, 18a) et pouvant être comprimé avec une certaine force de pression (F) sur la surface du module solaire (1), **caractérisé en ce que** le racloir rotatif (6, 6a) présente des griffes ou des dents (9a-9f) comportant des surfaces latérales (17) et des surfaces avant (16) et dans lequel les surfaces avant (16) des griffes ou des dents (9a-9f) sont réalisées sous la forme de surfaces abrasives.

2. Dispositif (100, 100a) selon la revendication 1, **caractérisé en ce que** la liaison entre le racloir rotatif (6, 6a) et l'arbre d'entraînement (18, 18a) est pivotante au moyen d'une rotule ou d'un joint universel de telle sorte que le racloir rotatif (6, 6a) s'ajuste au moyen des surfaces avant (16) sur la surface du module solaire (1).

3. Dispositif (100, 100a) selon la revendication 2, **caractérisé en ce que** la liaison pivotante entre le racloir rotatif (6) et l'arbre d'entraînement (18) présente une broche de liaison (19) pouvant être insérée dans un trou oblong (15).

4. Dispositif (100, 100a) selon la revendication 2, **caractérisé en ce que** la liaison pivotante entre le racloir rotatif (6a) et l'arbre d'entraînement (18a) présente une tête sphérique (20a) munie de fentes (22a-22c) dans lesquelles peuvent être insérées des tiges d'entraînement (23a-23c) d'un réceptacle (7a) du racloir rotatif (6a).

5. Dispositif (100, 100a) selon l'une quelconque des revendications précédentes, **caractérisé en ce que** le module solaire (1) peut être fixé à un chariot, lequel chariot peut être déplacé de manière à être guidé pour passer devant le dispositif (100, 100a).

6. Dispositif (100, 100a) selon l'une quelconque des revendications précédentes, **caractérisé en ce que** les surfaces avant (16) forment avec les surfaces latérales (17) un angle (W) se situant dans un intervalle de 50 à 130°, mais s'élevant de préférence à 90°.

7. Dispositif (100, 100a) selon l'une quelconque des revendications précédentes, **caractérisé en ce que** la force de pression (F) peut être générée et amenée à varier par un cylindre pneumatique (27).

8. Dispositif (100, 100a) selon l'une quelconque des revendications précédentes, **caractérisé en ce que** le matériau du racloir rotatif (6, 6a) est plus dur que les matériaux d'une couche d'absorbant (12) et d'une couche de TCO (13) du module solaire (1) et est plus mou que le matériau d'une métallisation (1) du module solaire (1).

9. Dispositif (100, 100a) selon l'une quelconque des revendications précédentes, **caractérisé en ce que** le racloir rotatif (6, 6a) peut être entraîné à la fois vers la gauche et vers la droite.

10. Dispositif (100, 100a) selon l'une quelconque des revendications précédentes, **caractérisé en ce que** le couple de l'arbre d'entraînement (18, 18a) peut être limité par un limiteur de couple.

11. Dispositif (100, 100a) selon l'une quelconque des revendications précédentes, **caractérisé en ce que** la métallisation (11) du module solaire (1) peut être mise sous tension, et **en ce que** lors d'un contact avec le dispositif (100, 100a), un signal de réduction de la force de pression (F) peut être fourni en sortie.

12. Dispositif (100, 100a) selon l'une quelconque des revendications précédentes, **caractérisé en ce que** des plaquettes réversibles peuvent être disposées sur les surfaces latérales (17) des griffes ou des dents (9a-9f).

13. Procédé d'enlèvement de couches d'un module solaire (1) au moyen d'un dispositif (100, 100a) selon l'une quelconque des revendications précédentes, comprenant les étapes consistant à :
a) fixer le module solaire (1) dans un système de fixation par rapport au dispositif (100, 100a) ;
b) faire tourner une racloir rotatif (6, 6a) muni de griffes ou de dents (9a-9f) présentant des surfaces latérales (17) et des surfaces avant (16) au moyen d'un arbre d'entraînement (18, 18a) autour d'une verticale (V) ou autour d'un axe de coordonnées perpendiculaire (Z),
c) abaisser le racloir rotatif (6, 6a) sur la surface supérieure d'une couche supérieure de TCO (13) du module solaire (1) de telle sorte que les faces avant (16) touchent la surface de la couche supérieure de TCO (13) ;
d) exercer sur le racloir rotatif (6, 6a) une force de pression (F) dans la direction de la verticale (V) ou de l'axe de coordonnées vertical (Z) ;
e) déplacer le racloir rotatif (6, 6a) dans la direction d'au moins un axe de coordonnées horizontal (X) par déplacement d'un chariot horizontal (29) et/ou par déplacement du système de fixation de l'étape a).
